# EUROPEAN PATENT APPLICATION

(11) **EP 3 061 801 A1**
(43) Date of publication of application: **31.08.2016**
(21) Application number: 14855994.1
(22) Date of filing: 20.10.2014
(51) Int. Cl.: C09K 11/80, H01L 33/50

(54) **SINGLE-CRYSTAL PHOSPHOR AND LIGHT-EMITTING DEVICE**

(30) Priority: 23.10.2013 JP 2013220682
(71) Applicant: Koha Co., Ltd., Tokyo 178-8511 (JP); National Institute for Materials Science, Tsukuba-shi, Ibaraki 305-0047 (JP)
(72) Inventor: INOMATA, Daisuke, Tokyo 178-8511 (JP); AOKI, Kazuo, Tokyo 178-8511 (JP); SHIMAMURA, Kiyoshi, Tsukuba-shi Ibaraki 305-0047 (JP); GARCIA VILLORA, Encarnacion Antonia, Tsukuba-shi Ibaraki 305-0047 (JP)
(74) Representative: Betten & Resch
(86) International application number: PCT/JP2014/077843
(87) International publication number: WO 2015/060254

(57) **Abstract**

As one of purposes, the present invention provides: a single-crystal phosphor which can exhibit excellent properties under high-temperature conditions; and a light-emitting device in which the phosphor is used. As one embodiment, a single-crystal phosphor is provided, which has a chemical composition represented by the compositional formula: (Y_{1-x-y-z}LuₓGd_{y}Ce_{z})₃₊ₐAl₅₋ₐO₁₂ (**0** ≤ x ≤ **0.9994**, **0** ≤ y ≤ **0.0669**, **0.0002** ≤ z ≤ **0.0067**, **-0.016** ≤ a ≤ **0.315**).

## Description

### [Technical Field]

This invention relates to a single crystal phosphor and a light emitting device.

### [Background Art]

A light emitting device is known which has a light emitting element comprised of an LED (light emitting diode) that emits blue light, and a phosphor that is excited by the light from that light emitting element and emits yellow light, to mix these emission colors to thereby radiate white light (see PTL 1 below, for example).

The light emitting device disclosed in PTL **1** is configured such that a particulate phosphor is contained in an epoxy resin and is disposed around the light emitting element for emitting blue light, to mix the light emitted by the light emitting element itself, and the yellow light emitted by the phosphor to thereby radiate white light.

### [Citation List]

### [Patent Literature]

[PTL**1**] JP-A-2010-155891

### [Summary of Invention]

### [Technical Problem]

Due to increases in power of the light emitting device, heat generation by the light emitting element may be a significant problem. Specifically, variations in light emission properties due to power fed to the element, and variations in properties caused by temperature rising of the phosphor affect each other, thereby leading to variations in properties of the light emitting device.

The phosphor generally has its inherent quantum efficiency (efficiency of converting exciting light to fluorescence) and its temperature quenching property (property that the quantum efficiency decreases with increasing temperature). The higher quantum efficiency allows for achieving the higher-intensity light emitting device using the phosphor, while the superior temperature quenching property allows use of the phosphor in the higher power light emitting device.

Thus, it is an object of the present invention to provide a single crystal phosphor that exhibits superior properties even under high temperature conditions, as well as a light emitting device using the phosphor.

### [Solution to Problem]

According to an embodiment of the invention, to achieve the above object, a single crystal phosphor defined by [1] to [7] below will be provided.
[1] A single crystal phosphor, comprising a composition represented by a composition formula (Y_{1-x-y-z}LuₓGd_{y}Ce_{z})₃₊ₐAl₅₋ₐO₁₂ (**0 ≤** x ≤ **0.9994,** 0 y ≤ **0.0669, 0.0002** ≤ z ≤ **0.0067, -0.016** ≤ a ≤ **0.315).**
[2] The single crystal phosphor according to [1], wherein a fluorescence peak wavelength at a temperature of **25** degrees C and an exciting light peak wavelength of **450** nm is not shorter than **514** nm and not longer than **544** nm, and wherein an internal quantum efficiency at a temperature of **300** degrees C and an exciting light peak wavelength of **450** nm is not lower than **0.90.**
[3] The single crystal phosphor according to [1], wherein a fluorescence peak wavelength at a temperature of **25** degrees C and an exciting light peak wavelength of **450** nm is longer than **544** nm and not longer than **546** nm, and wherein an internal quantum efficiency at a temperature of **300** degrees C and an exciting light peak wavelength of **450** nm is not lower than **0.80**.
[4] The single crystal phosphor according to [1] or [2], wherein a fluorescence peak wavelength at a temperature of **25** degrees C and an exciting light peak wavelength of **450** nm is not shorter than **514** nm and not longer than **544** nm, and wherein a value of a ratio of an internal quantum efficiency at a temperature of **300** degrees C and an exciting light peak wavelength of **450** nm, to an internal quantum efficiency at a temperature of **25** degrees C and an exciting light peak wavelength of **450** nm is not lower than **0.90.**
[5] The single crystal phosphor according to [1] or [3], wherein a fluorescence peak wavelength at a temperature of **25** degrees C and an exciting light peak wavelength of **450** nm is longer than **544** nm and not longer than **546** nm, and wherein a value of a ratio of an internal quantum efficiency at a temperature of **300** degrees C and an exciting light peak wavelength of **450** nm, to an internal quantum efficiency at a temperature of **25** degrees C and an exciting light peak wavelength of **450** nm is not lower than **0.80.**
[6] The single crystal phosphor according to [1] or [2], wherein a fluorescence peak wavelength at a temperature of **25** degrees C and an exciting light peak wavelength of **450** nm is not shorter than **514** nm and not longer than **544** nm, and wherein a value of a ratio of an external quantum efficiency at a temperature of **300** degrees C and an exciting light peak wavelength of **450** nm, to an external quantum efficiency at a temperature of **25** degrees C and an exciting light peak wavelength of **450** nm is not lower than **0.85.**
[7] The single crystal phosphor according to [1] or [3], wherein a fluorescence peak wavelength at a temperature of **25** degrees C and an exciting light peak wavelength of **450** nm is longer than **544** nm and not longer than **546** nm, and wherein a value of a ratio of an external quantum efficiency at a temperature of **300** degrees C and an exciting light peak wavelength of **450** nm, to an external quantum efficiency at a temperature of **25** degrees C and an exciting light peak wavelength of **450** nm is not lower than **0.80.**
   Also, according to another embodiment of the invention, to achieve the above object, a light emitting device defined by [8] will be provided.
[8] A light emitting device, comprising:
   a light emitting element to emit bluish light; and
   a single crystal phosphor to absorb the light emitted by the light emitting element and emit yellowish fluorescence,
   wherein the single crystalline phosphor comprises the single crystal phosphor according to any one of [1] to [3].
[9] A light emitting device, comprising:
   a light emitting element to emit bluish light; and
   a single crystal phosphor to absorb the light emitted by the light emitting element and emit yellowish fluorescence,
   wherein the single crystalline phosphor comprises the single crystal phosphor according to [4].
[10] A light emitting device, comprising:
   a light emitting element to emit bluish light; and
   a single crystal phosphor to absorb the light emitted by the light emitting element and emit yellowish fluorescence,
   wherein the single crystalline phosphor comprises the single crystal phosphor according to [5].
[11] A light emitting device, comprising:
   a light emitting element to emit bluish light; and
   a single crystal phosphor to absorb the light emitted by the light emitting element and emit yellowish fluorescence,
   wherein the single crystalline phosphor comprises the single crystal phosphor according to [6].
[12] A light emitting device, comprising:
   a light emitting element to emit bluish light; and
   a single crystal phosphor to absorb the light emitted by the light emitting element and emit yellowish fluorescence,
   wherein the single crystalline phosphor comprises the single crystal phosphor according to [7].

### [Advantageous effects of the invention]

According to an embodiment of the invention, a single crystal phosphor can be provided that exhibits superior properties even under high temperature conditions, as well as a light emitting device using the phosphor.

### [Brief Description of Drawings]

[FIG.1] FIG **1** is a cross sectional view schematically showing a pulling of a single crystal phosphor ingot by the CZ method in a first embodiment.
[FIG.**2**A] FIG. **2**A is a graph showing relationships between the fluorescence peak wavelength (nm) and the internal quantum efficiency ηᵢₙₜ (**300** degrees C), of single crystal phosphors in the first embodiment.
[FIG.2B] FIG. 2B is a graph showing relationships between the fluorescence peak wavelength (nm), and the value of the internal quantum efficiency ratio, ηᵢₙₜ (**300** degrees C) / ηᵢₙₜ (**25** degrees C), of the single crystal phosphors in the present embodiment.
[FIG.3] FIG. **3** is a graph showing relationships between the fluorescence peak wavelength (nm), and the value of the external quantum efficiency ratio ηₑₓₜ (**300** degrees C) / ηₑₓₜ (**25** degrees C), of the single crystal phosphors in the first embodiment.
[FIG.4A] FIG. **4A** is a vertical cross sectional view showing a light emitting device in a second embodiment.
[FIG.4B] FIG. **4B** is a vertical cross sectional view showing a light emitting element constituting that light emitting device and its peripheral portion.
[FIG.5A] FIG. **5**A is a vertical cross sectional view showing a light emitting device in a third embodiment.
[FIG.5B] FIG. **5**B is a vertical cross sectional view showing a light emitting element constituting that light emitting device.
[FIG.5C] FIG. **5**C is a plan view showing the light emitting element.
[FIG.6] FIG. **6** is a vertical cross sectional view showing a light emitting device in a fourth embodiment.
[FIG.7] FIG. **7** is a vertical cross sectional view showing a light emitting device in a fifth embodiment.
[FIG.8A] FIG. **8**A is a vertical cross sectional view showing a light emitting device in a sixth embodiment.
[FIG.8B] FIG. **8**B is a vertical cross sectional view showing a light emitting element constituting that light emitting device.
[FIG.9] FIG. **9** is a vertical cross sectional view showing a light emitting device in a seventh embodiment.
[FIG.10A] FIG. **10A** is a vertical cross sectional view showing a light emitting device in an eighth embodiment.
[FIG.10B] FIG. **10**B is a vertical cross sectional view showing a light emitting device constituting that light emitting device and its peripheral portion.
[FIG.11] FIG. **11** is a vertical cross sectional view showing a light emitting device in a ninth embodiment.

### [Description of Embodiments]

### [First embodiment]

### [Single crystal phosphor]

A single crystal phosphor in a first embodiment is an yttrium aluminum garnet (YAG) based phosphor having an **Y₃Al₅O₁₂** (YAG) crystal as a parent crystal, and has a composition represented by the composition formula (Y_{1-x-y-z}LuₓGd_{y}Ce_{z})₃₊ₐAl₅₋ₐO₁₂ (**0** ≤ x ≤ **0.9994, 0** ≤ y ≤ **0.0669, 0.0002 ≤** z ≤ **0.0067, -0.016** ≤ a ≤ **0.315**). Here, the Lu and Gd are components which do not act as an emission center to be substituted in place of the Y The Ce is a component (activator) that can act as an emission center to be substituted in place of the Y.

It should be noted that, of the composition of the above mentioned single crystal phosphor, some atoms may occupy different crystal structural positions. Also, the value of O in the composition ratio in the above composition formula is written as **12**, but the above-described composition includes a composition whose O value in the composition ratio slightly deviates from **12** due to inevitable ingress or loss of oxygen. Also, the value of a in the composition formula is an inevitably varying value in the production of the single crystal phosphor, but changes within the numerical range of the order of **-0.016** ≤ a ≤ **0.315** have little effect on the physical properties of the single crystal phosphor.

Also, the phosphor of the present embodiment is free of group **2** elements such as Ba, Sr, etc., and group **17** elements such as F, Br, etc., and has a high purity. These features allow for ensuring the high intensity and long life phosphor.

The range of the value of z in the composition formula representing the Ce concentration is **0.0002** ≤ z ≤ **0.0067,** because when the value of y is smaller than **0.0002,** the Ce concentration is too low, therefore the absorption of exciting light decreases, and the external quantum efficiency is too low, while when the value of y is greater than **0.0067,** cracks, voids or the like form when an ingot of the single crystal phosphor is grown, and the crystal quality is highly likely to degrade.

This single crystal phosphor can be produced, for example by a liquid phase growth method such as the CZ method (Czochralski Method), the EFG method (Edge Defined Film Fed Growth Method), the Bridgman method, the FZ method (Floating Zone Method), the Bernoulli method, or the like. By cutting the ingot of the single crystal phosphor obtained by these liquid-phase growth methods into a flat plate shape, or by pulverizing that ingot into powder, it can be used in a light emitting device to be described later.

The single crystal phosphor of the present embodiment has superior internal quantum efficiency. For example, the internal quantum efficiency is not lower than **0.91** at a temperature of **25** degrees C and an exciting light peak wavelength of **450** nm.

According to the literature Solid-State Lighting Research and Development: Multi Year Program Plan March **2011** (Updated May **2011**) P.**69**, Table A**1.3**, it is described that the numerical value in the year **2010** of the internal quantum efficiency (Quantum Yield (**25** degrees C) across the visible spectrum) is **0.90,** and the year **2020** target value is to be **0.95.** From this, it is seen that in the industry, a quantum efficiency enhancement on the order of **0.01** in **2** years is expected, and it can be said that the phosphor of the present embodiment is the superior phosphor having a quantum efficiency close to, or exceeding that targeted value at the time of filing.

Further, at least some of the single crystal phosphors of the present embodiment (though its details will be described later) have an internal quantum efficiency of not lower than **0.90** at a temperature of **300** degrees C and an exciting light peak wavelength of **450** nm, in a sample whose fluorescence peak wavelength is not shorter than **514** nm and not longer than **544** nm at a temperature of **25** degrees C and an exciting light peak wavelength of **450** nm.

Further, in a sample whose fluorescence peak wavelength is longer than **544** nm and not longer than **546** nm at a temperature of **25** degrees C and an exciting light peak wavelength of **450** nm, the internal quantum efficiency is not lower than **0.80** at a temperature of **300** degrees C and an exciting light peak wavelength of **450** nm.

These single crystal phosphors can maintain a high internal quantum efficiency even under a high temperature condition of **300** degrees C, therefore can exhibit their superior function as phosphors to be used in light emitting devices having a very high intensity per unit area, such as laser projectors or laser headlights whose exciting light is laser light.

Further, the single crystal phosphors exhibiting the high internal quantum efficiency at the above described temperature of **300** degrees C have a superior temperature quenching property. For example, in a sample whose fluorescence peak wavelength is not shorter than **514** nm and not longer than **544** nm at a temperature of **25** degrees C and an exciting light peak wavelength of **450** nm, the value of the ratio of the internal quantum efficiency at a temperature of **300** degrees C and an exciting light peak wavelength of **450** nm, to the internal quantum efficiency at a temperature of **25** degrees C and an exciting light peak wavelength of **450** nm is not lower than **0.90.**

Further, in a sample whose fluorescence peak wavelength is longer than **544** nm and not longer than **546** nm at a temperature of **25** degrees C and an exciting light peak wavelength of **450** nm, the value of the ratio of the internal quantum efficiency at a temperature of **300** degrees C and an exciting light peak wavelength of **450** nm, to the internal quantum efficiency at a temperature of **25** degrees C and an exciting light peak wavelength of **450** mm is not lower than **0.80**.

Further, for example, in a sample whose fluorescence peak wavelength is not shorter than **514** nm and not longer than **544** nm at a temperature of **25** degrees C and an exciting light peak wavelength of **450** nm, the value of the ratio of the external quantum efficiency at a temperature of **300** degrees C and an exciting light peak wavelength of **450** nm, to the external quantum efficiency at a temperature of **25** degrees C and an exciting light peak wavelength of **450** nm is not lower than **0.85.**

Further, in a sample whose fluorescence peak wavelength is longer than **544** nm and not longer than **546** nm at a temperature of **25** degrees C and an exciting light peak wavelength of **450** nm. the value of the ratio of the external quantum efficiency at a temperature of **300** degrees C and an exciting light peak wavelength of **450** nm, to the external quantum efficiency at a temperature of **25** degrees C and an exciting light peak wavelength of **450** nm is not lower than **0.80.**

### [Comparison with a poly crystal phosphor]

A YAG based single crystal phosphor and a YAG based poly crystal phosphor powder, which are activated by Ce, significantly differ in the relationship between the Ce concentration and the emission color. For example, a patent document **(**JP-A-2010-24278**)** describes that a poly crystal phosphor powder having a composition represented by the composition formula (Y_{1-z}Ce_{z})₃Al₅O₁₂ emits light of a constant chromaticity **(0.41, 0.56)** in a Ce concentration range of **0.003 ≤** z ≤ **0.2.** On the other hand, in the single crystal phosphor of the present embodiment, the chromaticity varies depending on the Ce concentration, and for example, the composition to emit light of the same chromaticity **(0.41, 0.56)** as that of the poly crystal phosphor powder of the above patent document is (Y_{1-z}Ce_{z})₃Al₅O₁₂ (z = **0.0005).**

Also, another patent document **(**JP-B-3503139**)** describes that a poly crystal phosphor powder having a composition represented by the composition formula (Y_{1-a-b}LuₐCe_{b})₃Al₅O₁₂ has an emission chromaticity of (**0.339**, **0.579**) when a = **0.99** and b = **0.01,** and an emission chromaticity of (**0.377, 0.570**) when a = **0.495** and b = **0.01**.
Also, the Ce concentration contained in this poly crystal phosphor powder is several orders of magnitude higher than the Ce concentration contained in the single crystal phosphor of the present embodiment.

In this manner, in the single crystal phosphor, the Ce concentration to be added to emit light of a desired color is very low in comparison with the poly crystal phosphor, making it possible to reduce the amount of the expensive Ce to be used.

Below will be described one example of a method for producing the single crystal phosphor in the present embodiment. In the following example, the single crystal phosphor is grown by the Czochralski method (CZ method).

### [Production of the single crystal phosphor]

First, as starting raw materials, high purity (**99.99**% or higher) powders of Y₂O₃, Lu₂O₃, Gd₂O₃, CeO₂, and Al₂O₃ are prepared, and dry mixed to produce a powder mixture. Incidentally, the raw material powders of Y, Lu, Gd, Ce, and Al are not limited to those described above. Further, when a single crystal phosphor containing no Lu or Gd is produced, no raw material powders thereof are used.

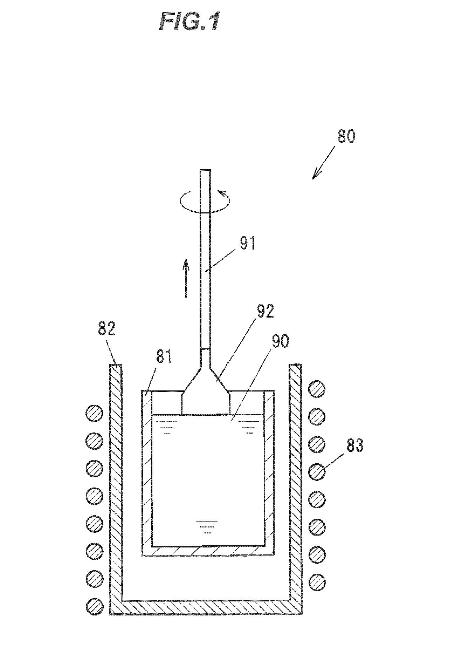

FIG. **1** is a cross sectional view schematically showing a pulling of a single crystal phosphor ingot by the CZ method. A crystal growing apparatus **80** mainly includes an iridium crucible **81,** a ceramic cylindrical container **82** for containing the crucible **81,** and a high-frequency coil **83** wound around the cylindrical container **82.**

The resulting powder mixture is installed in the crucible **81,** and a high frequency energy of **30** kW is fed by the high frequency coil **83** in a nitrogen atmosphere to the crucible **81** to induce current to heat the crucible **81.** This melts the powder mixture to produce a melt **90.**

Next, a seed crystal **91** that is the YAG single crystal is prepared, and its tip is brought into contact with the melt **90,** and thereafter is rotated at a rotational speed of **10** rpm, while being pulled at a pulling speed of **1** mm/h or less, to grow a single crystal phosphor ingot **92** in the <**111**> direction at a pulling temperature of **1960** degrees C or higher. The growth of the single crystal phosphor ingot **92** is conducted under atmospheric pressure, in the nitrogen atmosphere, by feeding the nitrogen into the cylindrical container at a flow rate of **2**L per minute.

This results in the single crystal phosphor ingot **92** of a diameter of about **2.5** cm, and a length of about **5**cm, for example. By cutting out the resulting single crystal phosphor ingot **92** to a desired size, a flat plate-shaped single crystal phosphor to be used in a light emitting device for example can be produced. Also, by pulverizing the single crystal phosphor ingot **92**, it is possible to produce a particulate single crystal phosphor.

### [Evaluation of the single crystal phosphor]

A plurality of single crystal phosphors having different compositions in the first embodiment were produced, and the analysis of the compositions, and the evaluation of CIE chromaticity, internal quantum efficiency, and external quantum efficiency were conducted.

The composition analysis was performed by high-frequency inductively coupled plasma (ICP) emission spectroscopy. Also, for single crystal phosphors having a very low Ce concentration, ICP mass spectrometry (ICP-MS) was used in combination.

In the evaluation of the CIE chromaticity coordinates, the CIE**1931** color matching function was used, and the CIE chromaticity coordinates of emission spectra of the single crystal phosphors at an exciting light peak wavelength of **450** nm were determined.

The evaluations of the internal quantum efficiency and the external quantum efficiency were performed by using a quantum efficiency measuring system with an integrating hemisphere unit. Below are described specific methods for measuring the internal quantum efficiency and the external quantum efficiency of the single crystal phosphors.

First, by irradiating exciting light to a barium sulfate powder as a standard sample installed in the integrating hemisphere unit, an exciting light spectrum is measured. Then, by irradiating exciting light to a single crystal phosphor installed on the barium sulfate in the integrating hemisphere unit, a reflected exciting light spectrum and a fluorescence emission spectrum are measured. Then, by irradiating the exciting light diffuse reflected in the integrating hemisphere unit to the single crystal phosphor installed on the barium sulfate, a re-excited fluorescence emission spectrum is measured.

Then, by dividing a difference between a photon number obtained from the fluorescence emission spectrum and a photon number obtained from the re-excited fluorescence emission spectrum by a difference between a photon number obtained from the exciting light spectrum and a photon number obtained from the reflected exciting light spectrum, the internal quantum efficiency is determined.

Further, by dividing the difference between the photon number obtained from the fluorescence emission spectrum and the photon number obtained from the re-excited fluorescence emission spectrum by the photon number obtained from the exciting light spectrum, the external quantum efficiency is determined.

Evaluated results are shown in Tables **1** and **2** below. Table **1** shows the evaluated results of single crystal phosphor samples Nos. **1** to **23,** and Table **2** shows the evaluated results of single crystal phosphor samples Nos. **24** to **46.**

Tables **1** and **2** show x, y, z, and a values in the composition formula of the single crystal phosphor in the present embodiment, measurement temperatures (degrees C) of the single crystal phosphors, internal quantum efficiencies (ηᵢₙₜ) at exciting light peak wavelengths of **440, 450,** and **460** nm, ηᵢₙₜ (**300** degrees C) / ηᵢₙₜ (**25** degrees C) serving as a measure of temperature properties of the internal quantum efficiencies ηᵢₙₜ, external quantum efficiencies (ηₑₓₜ) at exciting light peak wavelengths of **440, 450,** and **460** nm, ηₑₓₜ (**300** degrees C) / ηₑₓₜ (**25** degrees C) serving as a measure of temperature properties of the external quantum efficiencies ηₑₓₜ, fluorescence peak wavelengths λp (nm) at the exciting light peak wavelength of **450** nm, and CIE chromaticity coordinates at the exciting light peak wavelength of **450** nm.

Here, ηᵢₙₜ (**300** degrees C) is the internal quantum efficiency at the temperature of **300** degrees C and the exciting light peak wavelength of **450** nm, ηᵢₙₜ (**25** degrees C) is the internal quantum efficiency at the temperature **of 25** degrees C and the exciting light peak wavelength of **450** nm, and ηᵢₙₜ (**300** degrees C) / ηᵢₙₜ (**25** degrees C) is the value of the ratio of ηᵢₙₜ (**300** degrees C) to ηᵢₙₜ (**25** degrees C). Further, ηₑₓₜ (**300** degrees C) is the external quantum efficiency at the temperature of **300** degrees C and the exciting light peak wavelength of **450** nm, ηₑₓₜ (**25** degrees C) is the external quantum efficiency at the temperature of **25** degrees C and the exciting light peak wavelength of **450** nm, and ηₑₓₜ (**300** degrees C) / ηₑₓₜ (**25** degrees C) is the value of the ratio of ηₑₓₜ (**300** degrees C) to ηₑₓₜ (**25** degrees C).

As to shapes of the samples of the evaluated single crystalline phosphors, Sample No. 2 was a circular plate of a diameter of **10** mm and a thickness of **1.0** mm, Samples Nos. **17** and **23** were circular plates of a diameter of **10** mm and a thickness of **0.3** mm, Sample No. **46** was powder, and the other samples were square plates of a one side length of **10** mm and a thickness of **0.3** mm. Also, all the samples except the powdered sample had both mirror polished surfaces.

Although the shapes of the samples in principle affect the measured values of the external quantum efficiencies, the values of the ratios of the external quantum efficiencies of the same samples, for example, the values of ηₑₓₜ (**300** degrees C) / ηₑₓₜ (**25** degrees C) do not depend on the shapes of the samples. On the other hand, the measured values of the internal quantum efficiencies are little affected by the shapes of the samples.

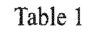

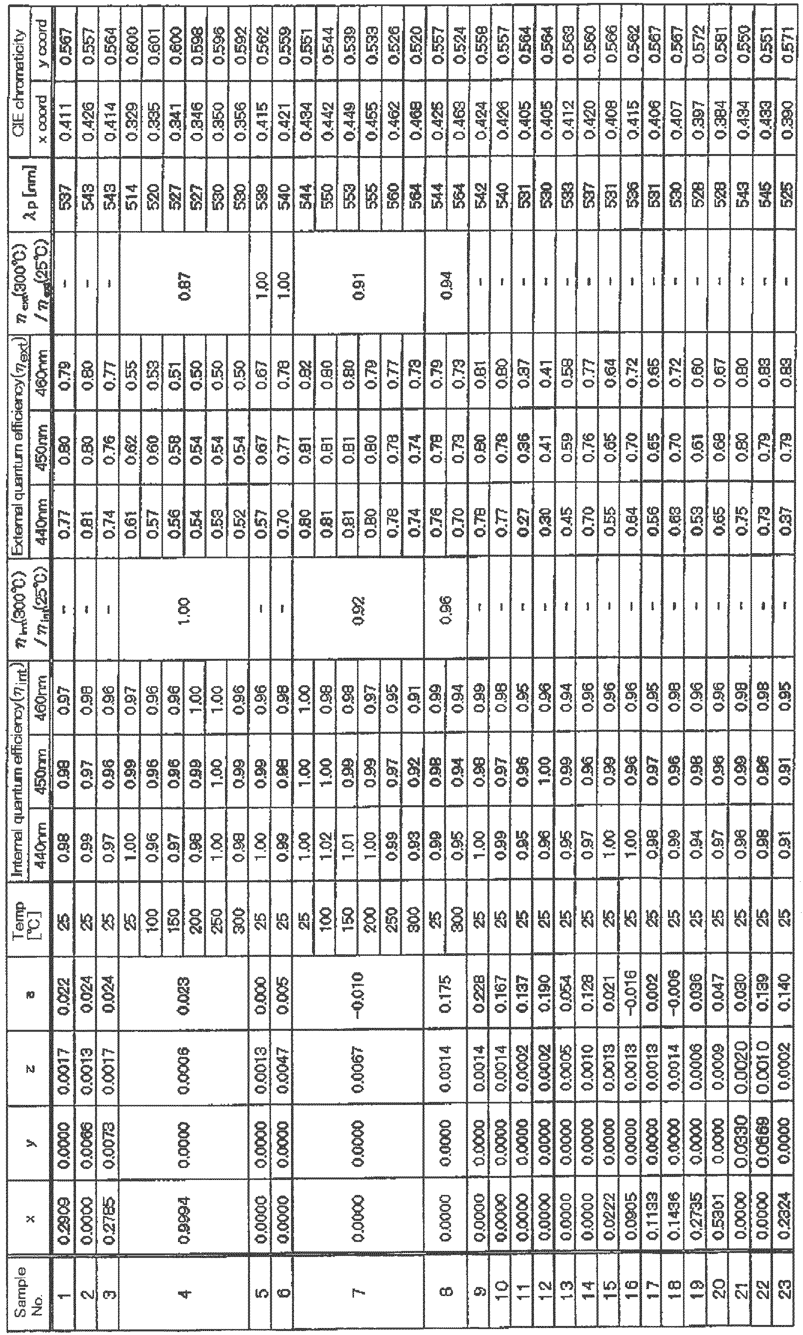

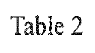

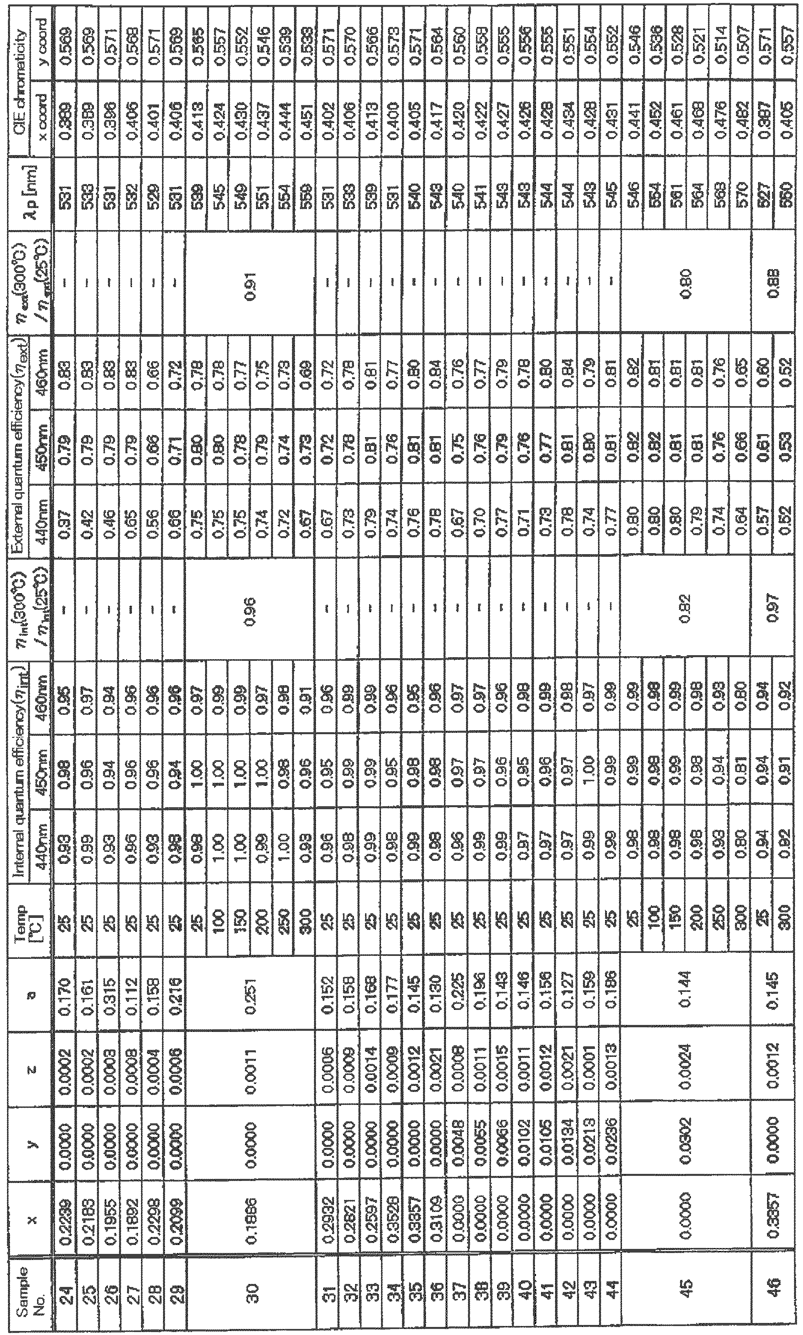

According to Table 1, the compositions of the samples of the evaluated single crystal phosphors were included in the composition represented by the composition formula (Y_{**1**-x-y-z}LuₓGd_{y}Ce_{z})_{**3**+a}Al₅₋ₐO_{1**2**} (**0** ≤ x ≤ **0.9994, 0** ≤ y ≤ **0.0669, 0.0002 ≤** z ≤ **0.0067, -0.016** ≤ a ≤ **0.315**).

According to Table 1, the internal quantum efficiencies at the temperature of 25 degrees C and the exciting light peak wavelength of **450** nm of all the samples of the single crystalline phosphors evaluated were not lower than **0.91.**

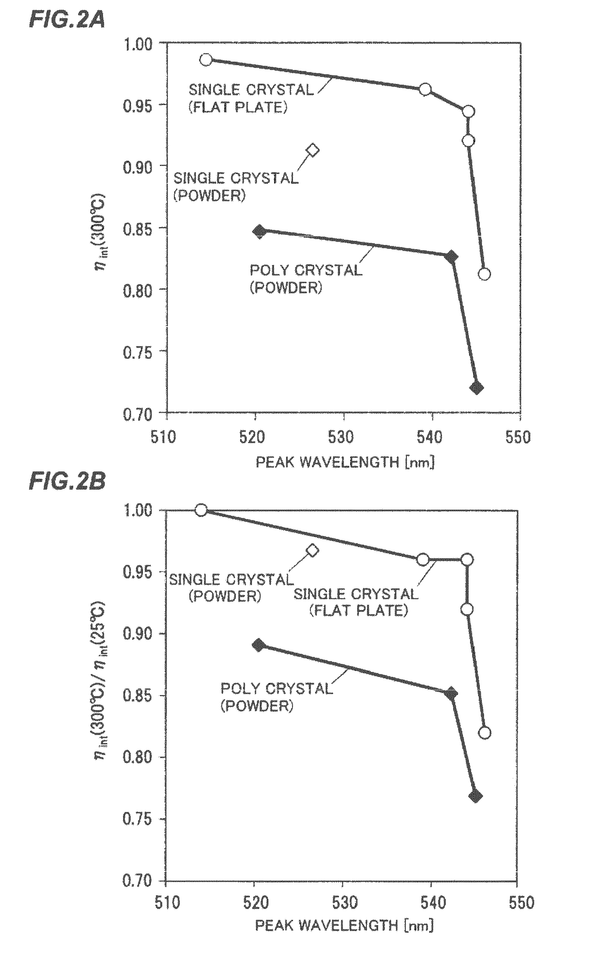

FIG. **2A** is a graph showing relationships between the fluorescence peak wavelength (nm) at a temperature of **25** degrees C and an exciting light peak wavelength of **450** nm and the internal quantum efficiency ηᵢₙₜ (**300** degrees C), of the single crystal phosphors in the present embodiment. Further, FIG. **2**B is a graph showing relationships between the fluorescence peak wavelength (nm) at a temperature **of 25** degrees C and an exciting light peak wavelength of **450** nm, and the value of the internal quantum efficiency ratio, ηᵢₙₜ (**300** degrees C) / ηᵢₙₜ (**25** degrees C), of the single crystal phosphors in the present embodiment.

In FIGS. **2**A and **2**B, the marks "○" are the measured values for the flat plate-shaped single crystal phosphors (samples Nos. **4, 7, 8, 30,** and **45**) in the present embodiment, the mark "◇" is the measured value for the powdery single crystal phosphor (sample No. **46**), and the marks "◆" are the measured values for YAG based poly crystal phosphor powders activated by Ce as comparative examples.

According to FIG. **2A****,** the internal quantum efficiencies ηᵢₙₜ (**300** degrees C) of the single crystal phosphors in the present embodiment were not lower than **0.90** in the samples whose fluorescence peak wavelength was not shorter than **514** nm and not longer than **544** nm at the temperature of **25** degrees C and the exciting light peak wavelength of **450** nm, and were not lower than **0.80** in the samples whose fluorescence peak wavelength was longer than **544** nm and not longer than **546** nm at the temperature of **25** degrees C and the exciting light peak wavelength of **450** nm.

Further, according to FIG. **2A****,** the internal quantum efficiencies ηᵢₙₜ (**300** degrees C) of the poly crystal phosphors were lower than the internal quantum efficiencies ηᵢₙₜ (**300** degrees C) of the single crystal phosphors in the present embodiment, and fell below **0.85** in the samples whose fluorescence peak wavelength was not shorter than **514** nm and not longer than **544** nm at the temperature of **25** degrees C and the exciting light peak wavelength of **450** nm, and fell below **0.75** in the samples whose fluorescence peak wavelength was longer than **544** nm and not longer than **546** nm at the temperature of **25** degrees C and the exciting light peak wavelength of **450** nm.

According to FIG. **2**B, the values of the internal quantum efficiency ratios of the single crystal phosphors in the present embodiment, ηᵢₙₜ (**300** degrees C) / ηᵢₙₜ (**25** degrees C) were not lower than **0.90** in the samples whose fluorescence peak wavelength was not shorter than **514** nm and not longer than **544** nm at the temperature of **25** degrees C and the exciting light peak wavelength of **450** nm, and were not lower than **0.80** in the samples whose fluorescence peak wavelength was longer than **544** nm and not longer than **546** nm at the temperature of **25** degrees C and the exciting light peak wavelength of **450** nm.

Further, according to FIG. **2**B, the values of the internal quantum efficiency ratios of the poly crystal phosphors, ηᵢₙₜ (**300** degrees C) / ηᵢₙₜ (**25** degrees C) were lower than the values of the internal quantum efficiency ratios of the single crystal phosphors in the present embodiment, ηᵢₙₜ (**300** degrees C) / ηᵢₙₜ (**25** degrees C), and fell below **0.90** in the samples whose fluorescence peak wavelength was not shorter than **514** nm and not longer than **544** nm at the temperature of **25** degrees C and the exciting light peak wavelength of **450** nm, and fell below **0.80** in the samples whose fluorescence peak wavelength was longer than **544** nm and not longer than **546** nm at the temperature of **25** degrees C and the exciting light peak wavelength of **450** nm.

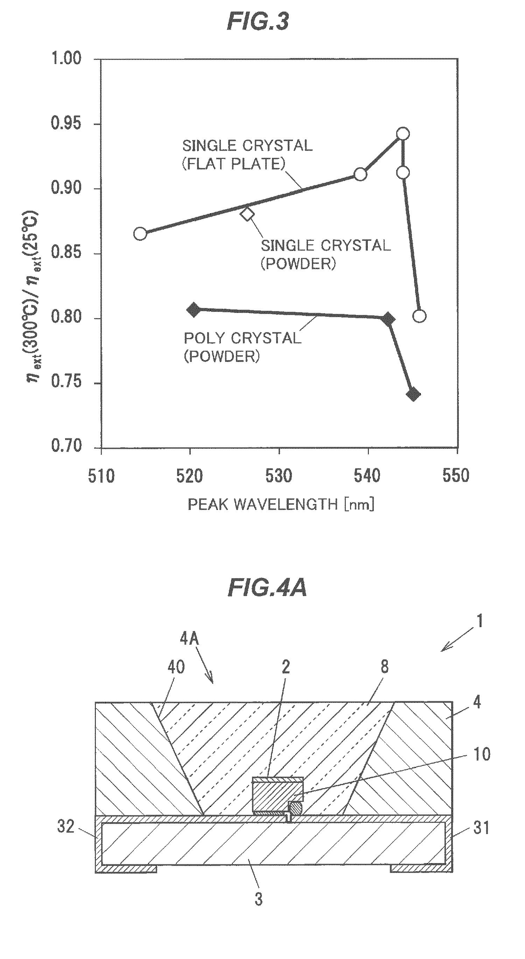

FIG. **3** is a graph showing relationships between the fluorescence peak wavelength (nm) at a temperature of **25** degrees C and an exciting light peak wavelength of **450** nm and the value of the external quantum efficiency ratio, ηₑₓₜ (**300** degrees C) / ηₑₓₜ (**25** degrees C), of the single crystal phosphor in the present embodiment.

In FIG. 3, the marks "○" are the measured values for the flat plate-shaped single crystal phosphors (samples Nos. **4**, 7, **8, 30**, and **45**) in the present embodiment, the mark "◇" is the measured value for the powdery single crystal phosphor (sample No. **46**), and the marks "◆" are the measured values for the YAG based poly crystal phosphor powders activated by Ce as the comparative examples.

According to FIG. 3, the values of the external quantum efficiency ratios of the single crystal phosphors in the present embodiment, ηₑₓₜ (**300** degrees C) / ηₑₓₜ (**25** degrees C) were not lower than **0.85** in the samples whose fluorescence peak wavelength was not shorter than **514** nm and not longer than **544** nm at the temperature **of 25** degrees C and the exciting light peak wavelength of **450** nm, and were not lower than **0.80** in the samples whose fluorescence peak wavelength was longer than **544** nm and not longer than **546** nm at the temperature of **25** degrees C and the exciting light peak wavelength of **450** nm.

According to FIG. **3****,** the values of the external quantum efficiency ratios of the poly crystal phosphors, ηₑₓₜ (**300** degrees C) / ηₑₓₜ (**25** degrees C) were lower than the values of the external quantum efficiency ratios of the single crystal phosphors in the present embodiment, ηₑₓₜ (**300** degrees C) / ηₑₓₜ (**25** degrees C), and fell below **0.85** in the samples whose fluorescence peak wavelength was not shorter than **514** nm and not longer than **544** nm at the temperature of **25** degrees C and the exciting light peak wavelength of **450** nm, and fell below **0.75** in the samples whose fluorescence peak wavelength was longer than **544** nm and not longer than **546** nm at the temperature of **25** degrees C and the exciting light peak wavelength of **450** nm.

### [Second embodiment]

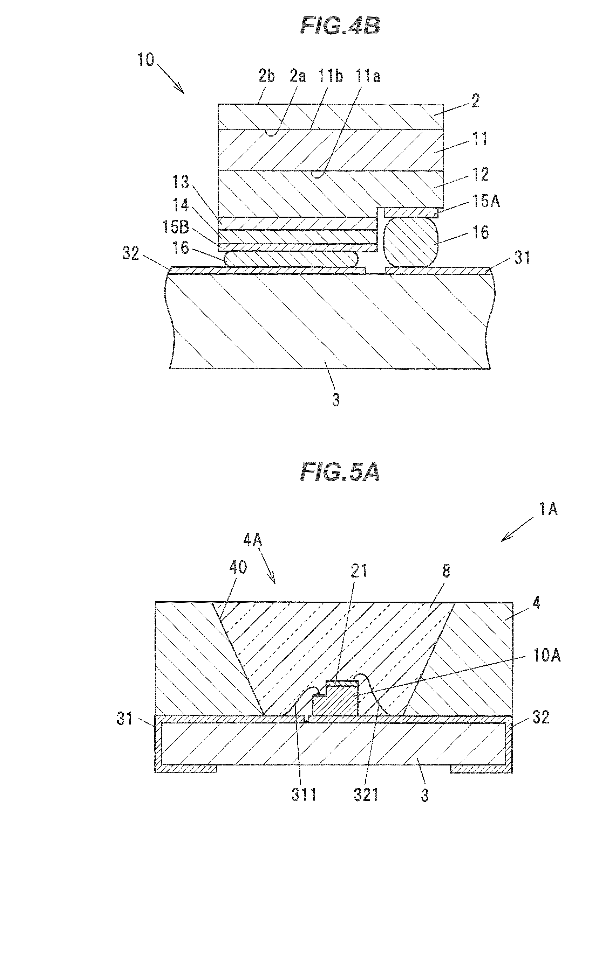

A second embodiment of the present invention relates to a light emitting device using a single crystal phosphor in the first embodiment. Hereinafter, the second embodiment will be described with reference to FIG. **4**A. FIG. **4**A is a vertical cross sectional view showing a light emitting device **1** in the second embodiment, while FIG **4B** is a vertical cross sectional view showing a light emitting element **10** constituting that light emitting device **1** and its peripheral portion.

As shown in FIG. **4A****,** the light emitting device **1** includes a light emitting element **10,** such as an LED (light emitting diode), a phosphor **2** made of the single crystal phosphor in the first embodiment, which is provided in such a manner as to cover a light emitting surface of the light emitting element **10,** a ceramic substrate **3** made of Al₂O₃ or the like for supporting the light emitting element **10,** a body **4** made of a white resin, and a transparent resin **8** for sealing the light emitting element **10** and the phosphor **2.**

The ceramic substrate **3** has wiring sections **31** and **32,** which are pattern formed from a metal, such as tungsten or the like. The wiring sections **31** and **32** are electrically connected to an n-side electrode **15**A and a p-side electrode **15**B, respectively, of the light emitting element **10.**

The body **4** is formed on the ceramic substrate **3,** and is formed with an opening **4**A through the middle thereof. The opening **4**A is formed in a tapered shape whose opening width gradually increases outward from the ceramic substrate **3** side. The inner surface of the opening **4**A is formed as a reflecting surface **40** to reflect light emitted from the light emitting element **10** outward.

As shown in FIG. **4**B, the n-side electrode **15**A and the p-side electrode 15B of the light emitting element **10** are connected via bumps **16** to the wiring sections **31** and **32** of the ceramic substrate **3,** respectively.

The light emitting element **10 is,** for example, a flip chip element using a GaN based semiconductor compound, and is designed to emit bluish light having a peak light intensity at a wavelength of **380** to **490** nm, for example. This light emitting element **10** is in turn formed with an n-type GaN layer **12,** a light emitting layer **13,** and a p-type GaN layer **14** on a first principal plane **11**a of an element substrate **11** made of sapphire or the like. On an exposed portion of the n-type GaN layer **12** is formed the n-side electrode **15**A, while over a surface of the p-type GaN layer **14** is formed the p-side electrode **15B**.

The light emitting layer **13** is designed in such a manner that carriers are injected from the n-type GaN layer **12** and the p-type GaN layer **14** to thereby emit bluish light. This emitted light is transmitted through the n-type GaN layer **12** and the element substrate **11** and is emitted from a second principal plane **11**b of the element substrate **11.** In other words, the second principal plane **11**b of the element substrate **11** is the light emitting surface of the light emitting element **10**.

On the second principal plane **11**b side of the element substrate **11**, the phosphor **2** is installed in such a manner as to cover the entire second principal plane **11**b. For example, when the phosphor **2** and the element substrate **11** are in direct contact, a first surface **2**a of the phosphor **2**, which is located opposite the element substrate **11**, and the second principal plane **11**b of the element substrate **11** are joined by intermolecular force.

The phosphor **2** is a plate-shaped single crystal phosphor. The plate-shaped single crystal phosphor does not need to be dispersed in the resin unlike particulate phosphor, therefore there are no problems such as variations, etc. in emission color caused by degradation of the resin due to light or heat. For this reason, light emitting devices using the plate-shaped single crystal phosphor such as the light emitting device **1** have very high long-term reliability under conditions of high intensity, high power, high temperatures, etc. The phosphor **2** is equal or larger in size than the second principal plane **11b.**

When the light emitting element **10** configured as described above is energized, electrons are injected through the wiring section **31,** the n-side electrode **15A**, and the n-type GaN layer **12** into the light emitting layer **13,** while holes are injected through the wiring section **32,** the p-side electrode **15**B, and the p-type GaN layer **14** into the light emitting layer **13,** resulting in light emission of the light emitting layer **13.** The blue light emitted by the light emitting layer **13** is transmitted through the n-type GaN layer **12** and the element substrate **11**, is emitted from the second principal plane **11b** of the element substrate **11**, and is incident on the first surface **2**a of the phosphor **2**.

Some of the light passed through the first surface **2**a acts as exciting light to excite an electron in the phosphor **2**. The phosphor **2** absorbs some of the bluish light from the light emitting element **10,** and wavelength converts into yellowish light having a peak light intensity at a wavelength of **514** to **546** nm for example.

Some of the bluish light passed into the phosphor **2** is absorbed into the phosphor **2**, wavelength converted, and emitted from the second surface **2**b of the phosphor **2** as yellowish light, while the remaining of the light passed into the phosphor **2** is emitted from the second surface **2**b of the phosphor **2** without being absorbed into the phosphor **2**. Since the blue color and the yellow color are complementary to each other, the light emitting device **1** emits white light with the blue light and the yellow light mixed together therein.

Further, the color temperature of the white light to be emitted by the light emitting device **1** can be set at **4500** K or higher. The color temperature of the white light can be adjusted according to the concentration of Lu or Gd in the phosphor **2,** or the concentration of Ce acting as an activator, and the like. Further, by the addition of a second phosphor having a longer wavelength fluorescence spectrum than the phosphor **2,** it is possible to adjust the color temperature of the white light to be emitted by the light emitting device **1** to lower than **4500** K.

### [Third embodiment]

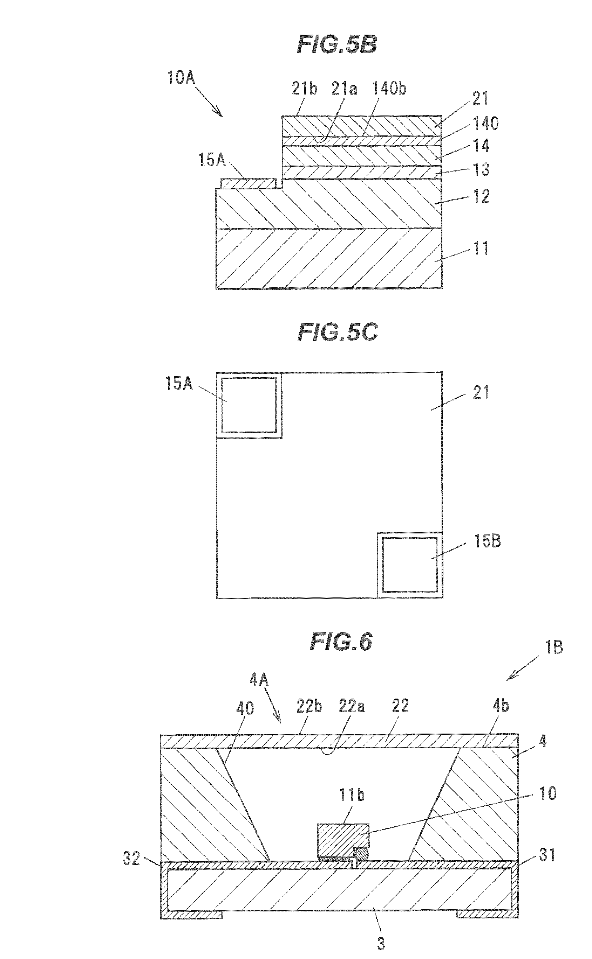

Next, a third embodiment of the present invention will be described with reference to FIGS. **5**A to **5**C. FIG. **5**A is a vertical cross sectional view showing a light emitting device **1A** in the third embodiment, FIG. **5**B is a vertical cross sectional view showing a light emitting element **10A** constituting that light emitting device **1**A, and FIG. **5**C is a plan view showing a light emitting element **10**A.

The light emitting device **1**A in the present embodiment is configured in the same manner as the light emitting device **1** in the second embodiment in that light emitted by its light emitting element is passed into its single crystal phosphor and wavelength converted, but differs from the second embodiment in the configuration of its light emitting element and the arrangement location of its phosphor relative to its light emitting element. Hereinafter, constituent elements of the light emitting device **1**A having the same functions and configurations as those of the second embodiment will be given common reference characters, and descriptions thereof will be omitted.

As shown in FIGS. **5**A and **5**B, the light emitting device **1**A is disposed in such a manner that an element substrate **11** of a light emitting element **10A** faces a ceramic substrate **3** side. Further, a phosphor **21** is joined to an opening **4**A side of the light emitting element **10**A. The phosphor **21,** as with the phosphor **2** in the second embodiment, is made of the single crystal phosphor in the first embodiment.

As shown in FIGS. 5B and **5**C, the light emitting element **10A** includes an element substrate **11**, an n-type GaN layer **12**, a light emitting layer. **13,** and a p-type GaN layer **14,** and further includes a transparent electrode **140** made of ITO (indium tin oxide: indium tin oxide) on the p-type GaN layer **14.** The transparent electrode **140** is formed with a p-side electrode **15**B thereon. The transparent electrode **140** is designed to diffuse carriers injected from the p-side electrode **15**B and inject them into the p-type GaN layer **14.**

As shown in FIG. **5C**, the phosphor **21** is formed in a substantially rectangular shape having cutouts on portions corresponding to the p-side electrode **15**B, and an n-side electrode **15**A, respectively, to be formed on the n-type GaN layer **12.** Further, the phosphor **21** has a first surface **21**a on the transparent electrode **140** side, which is joined by intermolecular force to a surface **140**b of the transparent electrode **140.**

As shown in FIG. **5**A, the n-side electrode **15**A of the light emitting element **10**A is connected to a wiring section **31** of the ceramic substrate **3** by a bonding wire **311.** Further, the p-side electrode **15**B of the light emitting element **10A** is connected to a wiring section **32** of the ceramic substrate **3** by a bonding wire **321**.

When the light emitting element **10A** configured as described above is energized, electrons are injected through the wiring section **31,** the n-side electrode **15**A**,** and the n-type GaN layer **12** into the light emitting layer **13,** while holes are injected through the wiring section **32,** the p-side electrode **15**B, the transparent electrode **140,** and the p-type GaN layer **14** into the light emitting layer **13,** resulting in light emission of the light emitting layer **13**.

The blue light emitted by the light emitting layer **13** is transmitted through the p-type GaN layer **14** and the transparent electrode **140,** and is emitted from the surface **140**b of the transparent electrode **140.** In other words, the surface **140**b of the transparent electrode **140** is the light emitting surface of the light emitting element **10**A. The light emitted from the surface **140**b of the transparent electrode **140** is incident on the first surface **21**a of the phosphor **21.**

Some of the light passed through the first surface **21**a into the phosphor **21** acts as exciting light to excite an electron in the phosphor **21.** The phosphor **21** absorbs some of the blue light from the light emitting element **10**A, and wavelength converts into yellow light. More specifically, the phosphor **21** absorbs the bluish light from the light emitting element **10**A, and emits yellowish light having an emission peak at a wavelength of **514** to **546** nm for example.

In this manner, some of the blue light passed into the phosphor **21** is absorbed into the phosphor **21,** wavelength converted, and emitted from the second surface **21b** of the phosphor **21** as yellow light, while the remaining of the blue light passed into the phosphor **21** is emitted from the second surface **21b** of the phosphor **21** without being absorbed into the phosphor **21.** Since the blue color and the yellow color are complementary to each other, the light emitting device **1A** emits white light with the blue light and the yellow light mixed together therein.

### [Fourth embodiment]

Next, a fourth embodiment of the present invention will be described with reference to FIG. **6**. FIG. **6** is a vertical cross sectional view showing a light emitting device **1**B in the fourth embodiment.

The light emitting device **1**B of the present embodiment is configured in the same manner as the light emitting device **1** in the second embodiment in that light emitted by its light emitting element is passed into its single crystal phosphor and wavelength converted, but differs from the second embodiment in the arrangement location of its phosphor. Hereinafter, constituent elements of the light emitting device **1**B having the same functions and configurations as those of the second or the third embodiment will be given common reference characters, and descriptions thereof will be omitted.

As shown in FIG. **6****,** the light emitting apparatus 1B includes a light emitting element **10** configured in the same manner as in the second embodiment on a ceramic substrate **3.** The light emitting element **10** is designed to emit blue light from a second principal plane **11**b of an element substrate **11** (FIG. **4**B) located on an opening **4**A side of a body **4** toward the opening **4**A side of the body **4.**

A phosphor **22** is joined to the body **4** such that it covers the opening **4**A of the body **4.** The phosphor **22** is formed in a flat plate shape, and is joined by an adhesive or the like to an upper surface **4**b of the body **4.** The phosphor **22,** as with the phosphor **2** in the second embodiment, is made of the single crystal phosphor in the first embodiment. Further, the phosphor **22** is larger than the light emitting element **10.**

When the light emitting device **1**B configured as described above is energized, the light emitting element **10** emits blue light from the second principal plane **11**b toward the phosphor **22.** The phosphor **22** absorbs the blue light emitted by the light emitting element **10** from a first surface **22**a facing the emitting surface of the light emitting element **10,** and radiates yellow fluorescence from a second surface **22**b to the outside.

In this manner, some of the blue light passed into the phosphor **22** is absorbed into the phosphor **22**, wavelength converted, and emitted from the second surface **22**b of the phosphor **22** as yellow light, while the remaining of the blue light passed into the phosphor **22** is emitted from the second surface **22**b of the phosphor **22** without being absorbed into the phosphor **22.** Since the blue color and the yellow color are complementary to each other, the light emitting device **1**B emits white light with the blue light and the yellow light mixed together therein.

In the present embodiment, since the light emitting element **10** and the phosphor **22** are spaced apart, as compared with when the phosphor is joined to the emitting surface of the light emitting element **10,** it is possible to use the large-size phosphor **22,** thereby enhancing ease of assembly of the light emitting device **1**B.

### [Fifth embodiment]

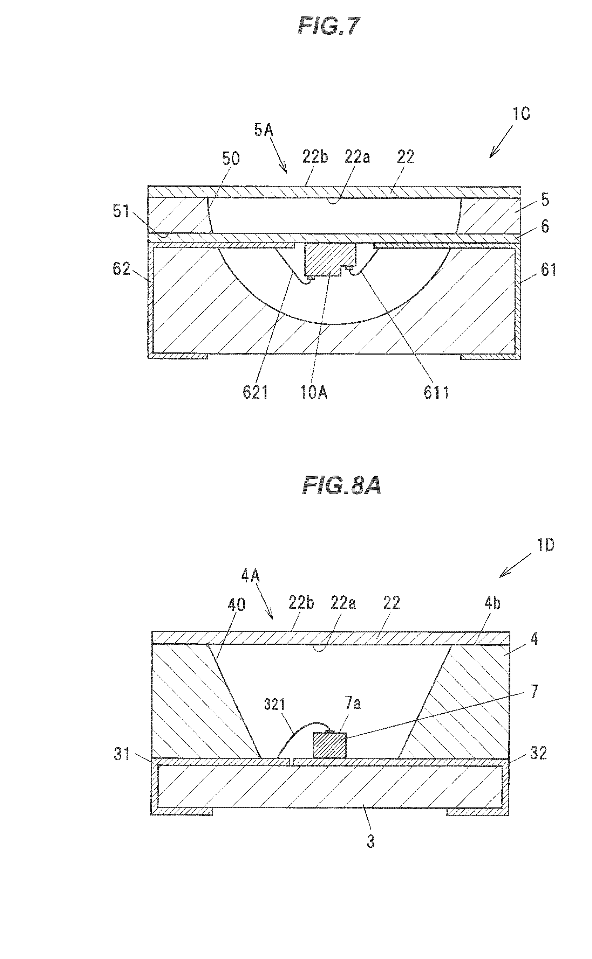

Next, a fifth embodiment of the present invention will be described with reference to FIG. **7**. FIG **7** is a cross sectional view showing a light emitting device **1**C in the fifth embodiment. As shown in FIG **7****,** the present embodiment differs from the fourth embodiment in the locational relationship between its light emitting element, and its substrate mounted with its light emitting element thereon and its phosphor. Hereinafter, constituent elements of the light emitting device **1**C having the same functions and configurations as those of the second, the third or the fourth embodiment will be given common reference characters, and descriptions thereof will be omitted.

The light emitting device **1**C in the present embodiment includes a body **5** made of a white resin, a transparent substrate **6,** which is held in a slit-shaped holding portion **51** formed in the body **5,** a phosphor **22,** which is arranged in such a manner as to cover an opening **5**A on the body **5,** a light emitting element **10**A, which is mounted on the opposite surface of the transparent substrate **6** to the phosphor **22** side surface thereof, wiring sections **61** and **62** for energizing the light emitting element **10A.** The phosphor **22,** as with the phosphor **2** in the second embodiment, is made of the single crystal phosphor in the first embodiment.

The body **5** is formed with a hemispherical concave portion at its center, and the surface of that concave portion is formed as a reflecting surface **50** to reflect light emitted by the light emitting element **10**A to the phosphor **22** side.

The transparent substrate **6** is made of a translucent resin such as a silicone resin, an acrylic resin, a PET (polyethylene terephthalate), or like, or a translucent member made of a single crystal or a poly crystal such as a glassy material, a sapphire, a ceramic, a quartz, or like, and has a translucency allowing light emitted by the light emitting element **10**A to pass therethrough and an electrical insulating property. Further, the transparent substrate **6** is being joined to respective portions of the wiring sections **61** and **62.** Ap-side electrode and an n-side electrode of the light emitting element **10**A are being electrically connected to respective one ends of the wiring sections **61** and **62** via bonding wires **611** and **621,** respectively. The respective other ends of the wiring sections **61** and **62** are being drawn out from the body **5.**

When the light emitting device **1C** configured as described above is energized, the light emitting element **10**A emits light in such a manner that some of the light emitted is transmitted through the transparent substrate **6** and is incident on a first surface **22a** of the phosphor **22,** while the other of the light emitted is reflected off a reflecting surface **50** of the body **5,** is transmitted through the transparent substrate **6** and is incident on the first surface **22a** of the phosphor **22.**

Some of the light passed into the phosphor **22** is absorbed into the phosphor **22,** and wavelength converted, while the remaining of the light passed into the phosphor **22** is emitted from a second surface **22**b of the phosphor **22** without being absorbed into the phosphor **22.** In this manner, the light emitting device **1**C mixes the blue light emitted by the light emitting element **10**A and the yellow light wavelength converted by the phosphor **22** together to emit white light.

With the present embodiment, the light emitted from the light emitting element **10**A to the opposite side to the phosphor **22** is reflected off the reflecting surface **50,** transmitted through the transparent substrate **6,** and passed into the phosphor **22,** therefore the light extraction efficiency of the light emitting device **1**C is high.

### [Sixth embodiment]

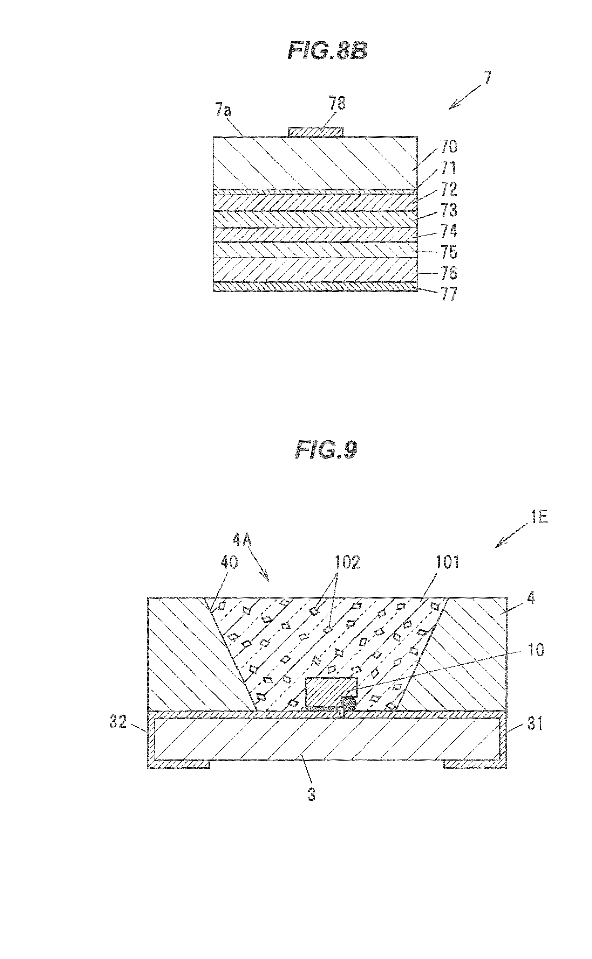

Next, a sixth embodiment of the present invention will be described with reference to FIGS. **8**A and **8**B. FIG. **8**A is a vertical cross sectional view showing a light emitting device **1**D in the sixth embodiment, and FIG. **8**B is a vertical cross sectional view showing a light emitting element **7** constituting that light emitting device **1**D. As shown in FIG. **8**A, the present embodiment differs from the fourth embodiment in the configuration of its light emitting element and the arrangement thereof. Hereinafter, constituent elements of the light emitting device **1**D having the same functions and configurations as those of the second, the third or the fourth embodiment will be given common reference characters, and descriptions thereof will be omitted.

In the light emitting device **1**D, the light emitting element **7** is arranged on a wiring section **32** provided on a ceramic substrate **3.** The light emitting element **7,** as shown in FIG. **8**B, is formed by in turn stacking a Ga₂O₃ substrate **70,** a buffer layer **71,** a Si-doped n⁺-GaN layer **72,** a Si-doped n-AlGaN layer **73,** an MQW (Multiple-Quantum Well) layer **74,** a Mg-doped p-AlGaN layer **75,** a Mg-doped p⁺-GaN layer **76,** and a p-electrode **77.** Further, on the opposite surface of the Ga₂O₃ substrate **70** to the buffer layer **71** is being provided an n-electrode **78.**

The Ga₂O₃ substrate **70** is made of β-Ga₂O₃ having n-type conductivity. The MQW layer **74** is a light emitting layer having an InGaN/GaN multiple quantum well structure. The p-electrode **77** is a transparent electrode made of an ITO (Indium Tin Oxide), and is being electrically connected to the wiring section **32.** The n-electrode **78** is being connected to a wiring section **31** of the ceramic substrate **3** by a bonding wire **321.** Note that the element substrate may use SiC (silicon carbide), in place of the β-Ga₂O₃.

When the light emitting element **7** configured as described above is energized, electrons are injected through the n-electrode **78,** the Ga₂O₃ substrate **70,** the buffer layer **71,** the Si-doped n⁺-GaN layer **72,** and the Si-doped n-AlGaN layer **73** into the MQW layer **74,** while holes are injected through the p-electrode **77,** the Mg-doped p⁺-GaN layer **76,** and the Mg-doped p-AlGaN layer **75** into the MQW layer **74,** resulting in bluish light emission. This bluish light emitted is transmitted through the Ga₂O₃ substrate **70,** etc., is emitted from an emitting surface **7**a of the light emitting element **7,** and is incident on a first surface **22**a of the phosphor **22**.

The phosphor **22** absorbs the bluish light emitted by the light emitting element **7** from the first surface **22**a facing the emitting surface **7**a of the light emitting element **7,** and emits yellow fluorescence from a second surface **22**b to the outside.

In this manner, some of the blue light passed into the phosphor **22** is absorbed into the phosphor **22,** wavelength converted, and emitted from the second surface **22**b of the phosphor **22** as yellow light, while the remaining of the blue light passed into the phosphor **22** is emitted from the second surface **22**b of the phosphor **22** without being absorbed into the phosphor **22.** Since the blue color and the yellow color are complementary to each other, the light emitting device **1**D emits white light with the blue light and the yellow light mixed together therein.

### [Seventh embodiment]

Next, a seventh embodiment of the present invention will be described with reference to FIG. **9**. FIG. **9** is a vertical cross sectional view showing a light emitting device **1**E in the seventh embodiment. As shown in FIG. **9****,** the present embodiment differs from the second embodiment in the configuration of its phosphor and the arrangement thereof. Hereinafter, constituent elements of the light emitting device **1**E having the same functions and configurations as those of the second embodiment will be given common reference characters, and descriptions thereof will be omitted.

As shown in FIG. **9****,** the light emitting device **1**E includes a light emitting element **10** such as an LED (light emitting diode), a ceramic substrate **3** for supporting the light emitting element **10,** a body **4** made of a white resin, and a transparent member **101** for sealing the light emitting element **10**.

A particulate phosphor **102** is being dispersed in the transparent member **101**. The phosphor **102** is made of the single crystal phosphor in the first embodiment, and is obtained for example by pulverizing the single crystal phosphor ingot **92** produced in the first embodiment.

The transparent member **101** is, for example, a transparent resin such as a silicone based resin, an epoxy based resin or the like, or a transparent inorganic material such as a glass or the like.

The phosphor **102** dispersed in the transparent member **101** absorbs some of bluish light emitted from the light emitting element **10,** and emits yellowish light having an emission peak at a wavelength of **514** to **546** nm, for example. The bluish light not absorbed into the phosphor **102,** and the yellowish fluorescence emitted from the phosphor **102** are mixed together, and white light is emitted from the light emitting device **1**E.

The transparent member **101** and the phosphor **102** in the present embodiment may be applied to another embodiment. In other words, the transparent member **101** and the phosphor **102** in the present embodiment may be used in place of the transparent resin **8** and the phosphor **21,** respectively, in the third embodiment.

### [Eighth embodiment]

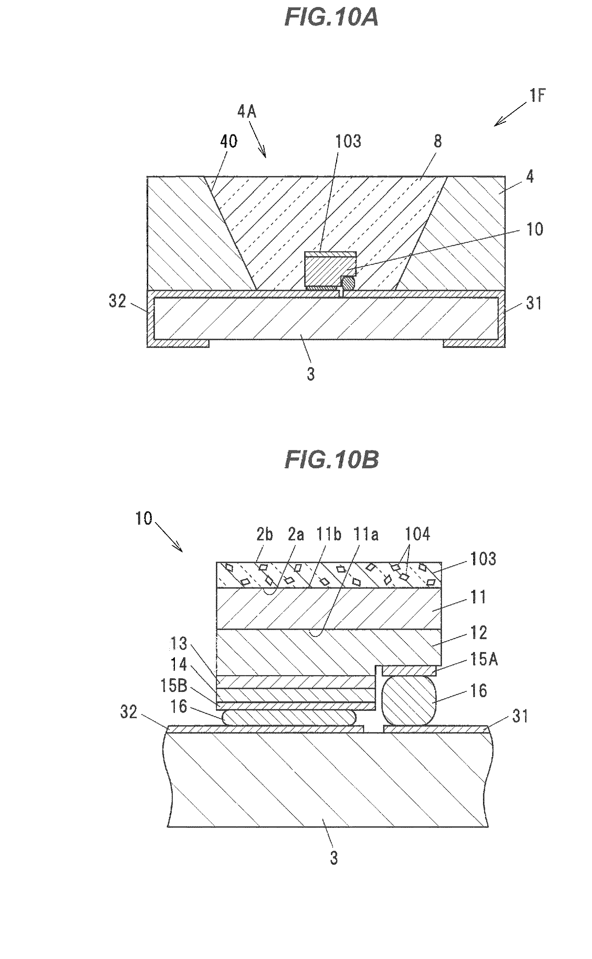

Next, an eighth embodiment of the present invention will be described with reference to FIGS. **10**A and **10**B. FIG. **10A** is a vertical cross sectional view showing a light emitting device **1F** in the eighth embodiment, and FIG. **10**B is a vertical cross sectional view showing a light emitting element **10** constituting that light emitting device **1F** and its peripheral portion. As shown in FIGS. **10A** and **10**B, the present embodiment differs from the second embodiment in the condition of its phosphor and the arrangement thereof. Hereinafter, constituent elements of the light emitting device **1**F having the same functions and configurations as those of the second embodiment will be given common reference characters, and descriptions thereof will be omitted.

As shown in FIG. **10**A, the light emitting device **1**F includes a light emitting element **10,** such as an LED (light emitting diode), a transparent member **103,** which is provided in such a manner as to cover the light emitting surface of the light emitting element **10,** a ceramic substrate **3** for supporting the light emitting element **10,** a body **4** made of a white resin, and a transparent resin **8** for sealing the light emitting element **10** and the transparent member **103.**

A particulate phosphor **104** is being dispersed in the transparent member **103.** The phosphor **104** is made of the single crystal phosphor in the first embodiment, and is obtained for example by pulverizing the single crystal phosphor ingot **92** produced in the first embodiment.

The transparent member **103** is, for example, a transparent resin such as a silicone based resin, an epoxy based resin or the like, or a transparent inorganic material such as a glass or the like. The transparent member **103** has the same shape and size as the phosphor 2 of the second embodiment, for example.

The phosphor **104** dispersed in the transparent member **103** absorbs some of bluish light emitted from the light emitting element **10,** and emits yellowish light having an emission peak at a wavelength of **514** to **546** nm, for example. The bluish light not absorbed into the phosphor **104,** and the yellowish fluorescence emitted from the phosphor **104** are mixed together, and white light is emitted from the light emitting device **1**F.

The transparent member **103** and the phosphor **104** in the present embodiment may be applied to other embodiments. For example, the transparent member **103** and the phosphor **104** in the present embodiment may be used in place of the phosphor **21** in the third embodiment, or the phosphor **22** in the fourth, the fifth, or the sixth embodiment.

### [Ninth embodiment]

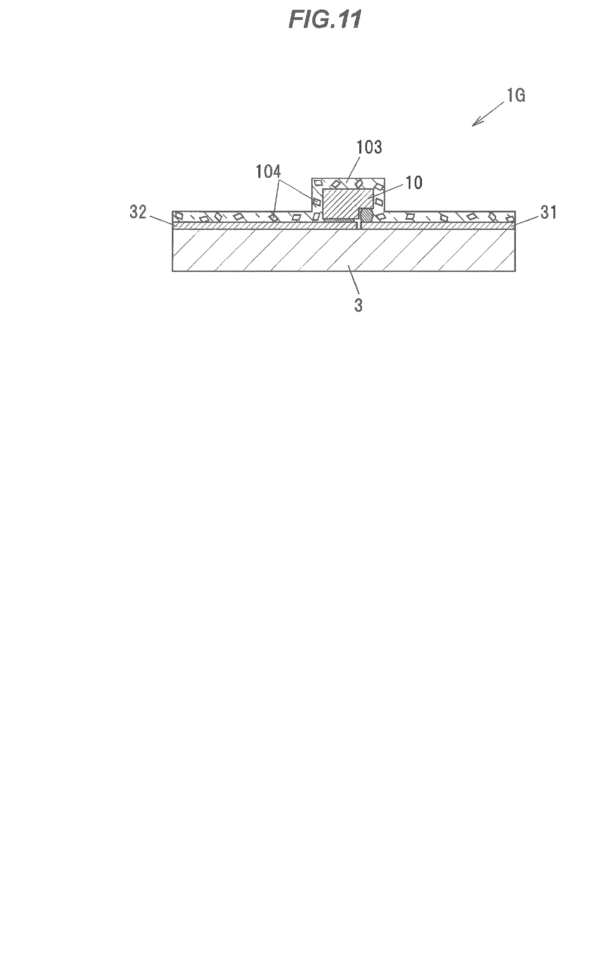

Next, a ninth embodiment of the present invention will be described with reference to FIG. **11**. FIG. **11** is a vertical cross sectional view showing a light emitting device **1**G in the ninth embodiment. As shown in FIG. **11****,** the present embodiment differs from the eighth embodiment in the shape of its transparent member including a particulate single crystal phosphor. Hereinafter, constituent elements of the light emitting device **1**G having the same functions and configurations as those of the eighth embodiment will be given common reference characters, and descriptions thereof will be omitted.

As shown in FIG. **11****,** the light emitting device **1**G includes a light emitting element **10,** such as an LED (light emitting diode), a ceramic substrate **3** for supporting the light emitting element **10,** and a transparent member **103,** which is provided in such a manner as to cover a surface of the light emitting element **10** and an upper surface of the ceramic substrate **3**.

A particulate phosphor **104** is being dispersed in the transparent member **103**. The phosphor **104** is made of the single crystal phosphor in the first embodiment, and is obtained for example by pulverizing the single crystal phosphor ingot **92** produced in the first embodiment.

The transparent member **103** is, for example, a transparent resin such as a silicone based resin, an epoxy based resin or the like, or a transparent inorganic material such as a glass or the like. Incidentally, although for the reason of its producing process using a coating method, etc., the transparent member **103** of the present embodiment is formed over the ceramic substrate **3** as well as over the surface of the light emitting element **10** in some cases, the transparent member **103** may not be formed over the ceramic substrate **3**.

The phosphor **104** dispersed in the transparent member **103** absorbs some of bluish light emitted from the light emitting element **10,** and emits yellowish light having an emission peak at a wavelength of **514** to **546** nm, for example. The bluish light not absorbed into the phosphor **104,** and the yellowish fluorescence emitted from the phosphor **104** are mixed together, and white light is emitted from the light emitting device **1**G.

### (Advantageous effects of the embodiments)

With the above described embodiments, it is possible to produce the phosphor superior in the quantum efficiencies and the temperature quenching property. Further, the use of the phosphor superior in the quantum efficiencies and the temperature quenching property allows for achieving the light emitting device having superior features such as high intensity, high power, long life, etc.

As apparent from the above descriptions, the present invention is not limited to the above described exemplary embodiments and illustrated examples, but various design alterations may be made within the scope specified in each of the appended claims. For example, although one example of the method for producing the phosphor has been shown, the phosphor of the present invention is not limited to that produced in this one example. Further, the light emitting element and the phosphor may be sealed with a so-called bullet shaped resin. Alternatively, one light emitting device may be configured in such a manner as to have a multiplicity of light emitting elements. Furthermore, the light emitting device may be constructed by combining a multiplicity of single monocrystalline phosphors, such as a single crystal phosphor, which uses light of a light emitting element emitting bluish light as exciting light to emit yellowish light, and a single crystal phosphor, which emits light of a color tone different from that of the aforementioned single crystal phosphor.

Further, the light emitting devices in the above embodiments such as LED light emitting devices or the like, or the single crystal phosphors to be used in those light emitting devices are high in energy efficiency, and capable of ensuring energy saving, therefore have an energy-saving effect.

### [Industrial Applicability]

The single crystal phosphors, which exhibit superior properties even under high temperature conditions, and the light emitting devices using those phosphors are provided.

### [Reference Sings List]

- 1, 1A, 1B, 1C, 1D, 1E, 1F, 1G: LIGHT EMITTING DEVICE
- 2, 21, 22, 102, 104: PHOSPHOR
- 3: CERAMIC SUBSTRATE
- 2a, 21a, 22a: FIRST SURFACE
- 2b, 21b,: 22b SECOND SURFACE
- 4, 5: BODY
- 51: HOLDING PORTION
- 4A, 5A: OPENING
- 4b: UPPER SURFACE
- 6: TRANSPARENT SUBSTRATE
- 10, 10A, 7: LIGHT EMITTING ELEMENT
- 11: ELEMENT SUBSTRATE
- 11a: FIRST PRINCIPAL PLANE
- 11b: SECOND PRINCIPAL PLANE
- 12: n-TYPE GaN LAYER
- 13: LIGHT EMITTING LAYER
- 14: p-TYPE GaN LAYER
- 15A: n-SIDE ELECTRODE
- 15B: p-SIDE ELECTRODE
- 16: BUMP
- 31, 32, 61, 62: WIRING SECTION
- 311, 321, 611, 621: BONDING WIRE
- 40, 50: REFLECTING SURFACE
- 140: TRANSPARENT ELECTRODE
- 140b: SURFACE
- 70: Ga₂O₃ SUBSTRATE
- 71: BUFFER LAYER
- 72: n⁺-GaN LAYER
- 73: n-AlGaN LAYER
- 74: MQW LAYER
- 75: p-AlGaN LAYER
- 76: p⁺-GaN LAYER
- 77: p-ELECTRODE
- 78: n-ELECTRODE
- 80: CRYSTAL GROWING APPARATUS
- 81: CRUCIBLE
- 82: CYLINDRICAL CONTAINER
- 83: HIGH FREQUENCY COIL
- 90: MELT
- 91: SEED CRYSTAL
- 92: SINGLE CRYSTAL PHOSPHOR INGOT
- 101, 103: TRANSPARENT MEMBER

## Claims

1. A single crystal phosphor, comprising a composition represented by a composition formula (Y_{1-x-y-z}LuₓGd_{y}Ce_{z})₃₊ₐAl₅₋ₐO₁₂ (**0** ≤ x ≤ **0.9994, 0 ≤** y ≤ **0.0669, 0.0002 ≤** z ≤ **0.0067, -0.016 ≤** a ≤ **0.315**).

2. The single crystal phosphor according to claim 1, wherein a fluorescence peak wavelength at a temperature of **25** degrees C and an exciting light peak wavelength of **450** nm is not shorter than **514** nm and not longer than **544** nm, and
wherein an internal quantum efficiency at a temperature of **300** degrees C and an exciting light peak wavelength of **450** nm is not lower than **0.90**.

3. The single crystal phosphor according to claim **1**, wherein a fluorescence peak wavelength at a temperature of **25** degrees C and an exciting light peak wavelength of **450** nm is longer than **544** nm and not longer than **546** nm, and
wherein an internal quantum efficiency at a temperature of **300** degrees C and an exciting light peak wavelength of **450** nm is not lower than **0.80.**

4. The single crystal phosphor according to claim **1** or **2**, wherein a fluorescence peak wavelength at a temperature of **25** degrees C and an exciting light peak wavelength of **450** nm is not shorter than **514** nm and not longer than **544** nm, and
wherein a value of a ratio of an internal quantum efficiency at a temperature of **300** degrees C and an exciting light peak wavelength of **450** nm, to an internal quantum efficiency at a temperature of **25** degrees C and an exciting light peak wavelength of **450** nm is not lower than **0.90.**

5. The single crystal phosphor according to claim **1** or **3,** wherein a fluorescence peak wavelength at a temperature of **25** degrees C and an exciting light peak wavelength of **450** nm is longer than **544** nm and not longer than **546** nm, and
wherein a value of a ratio of an internal quantum efficiency at a temperature of **300** degrees C and an exciting light peak wavelength of **450** nm, to an internal quantum efficiency at a temperature **of 25** degrees C and an exciting light peak wavelength of **450** nm is not lower than **0.80.**

6. The single crystal phosphor according to claim **1** or **2*,*** wherein a fluorescence peak wavelength at a temperature of **25** degrees C and an exciting light peak wavelength of **450** nm is not shorter than **514** nm and not longer than **544** nm, and
wherein a value of a ratio of an external quantum efficiency at a temperature of **300** degrees C and an exciting light peak wavelength of **450** nm, to an external quantum efficiency at a temperature of **25** degrees C and an exciting light peak wavelength of **450** nm is not lower than **0.85**.

7. The single crystal phosphor according to claim **1** or **3**, wherein a fluorescence peak wavelength at a temperature of **25** degrees C and an exciting light peak wavelength of **450** nm is longer than **544** nm and not longer than **546** nm, and
wherein a value of a ratio of an external quantum efficiency at a temperature of **300** degrees C and an exciting light peak wavelength of **450** nm, to an external quantum efficiency at a temperature of **25** degrees C and an exciting light peak wavelength of **450** nm is not lower than **0.80.**

8. A light emitting device, comprising:
a light emitting element to emit bluish light; and
a single crystal phosphor to absorb the light emitted by the light emitting element and emit yellowish fluorescence,
wherein the single crystalline phosphor comprises the single crystal phosphor according to any one of claims **1** to **3**.

9. A light emitting device, comprising:
a light emitting element to emit bluish light; and
a single crystal phosphor to absorb the light emitted by the light emitting element and emit yellowish fluorescence,
wherein the single crystalline phosphor comprises the single crystal phosphor according to claim **4**.

10. A light emitting device, comprising:
a light emitting element to emit bluish light; and
a single crystal phosphor to absorb the light emitted by the light emitting element and emit yellowish fluorescence,
wherein the single crystalline phosphor comprises the single crystal phosphor according to claim **5**.

11. A light emitting device, comprising:
a light emitting element to emit bluish light; and
a single crystal phosphor to absorb the light emitted by the light emitting element and emit yellowish fluorescence,
wherein the single crystalline phosphor comprises the single crystal phosphor according to claim **6**.

12. A light emitting device, comprising:
a light emitting element to emit bluish light; and
a single crystal phosphor to absorb the light emitted by the light emitting element and emit yellowish fluorescence,
wherein the single crystalline phosphor comprises the single crystal phosphor according to claim **7**.
